(19) Europäisches Patentamt

European Patent Office

Office européen des brevets

(11) **EP 1 512 021 B1**

(12) **EUROPÄISCHE PATENTSCHRIFT**

(45) Veröffentlichungstag und Bekanntmachung des Hinweises auf die Patenterteilung:
**29.03.2006 Patentblatt 2006/13**

(21) Anmeldenummer: **03755097.7**

(22) Anmeldetag: **12.05.2003**

(51) Int Cl.:
*G01R 19/00* (2006.01)   *G01R 19/32* (2006.01)
*G01R 33/07* (2006.01)

(86) Internationale Anmeldenummer:
**PCT/EP2003/004908**

(87) Internationale Veröffentlichungsnummer:
**WO 2003/100447 (04.12.2003 Gazette 2003/49)**

(54) **SCHALTUNGSANORDNUNG UND VERFAHREN ZUR KOMPENSATION DER ÄNDERUNGEN EINES ÜBERTRAGUNGSFAKTORS EINER MAGNETFELDSENSORANORDNUNG**

CIRCUIT CONFIGURATION AND METHOD FOR COMPENSATING FOR THE CHANGES IN A TRANSFER RATIO OF A MAGNETIC FIELD SENSOR ARRANGEMENT

MONTAGE ET PROCEDE POUR COMPENSER LES VARIATIONS D'UN FACTEUR DE TRANSMISSION D'UN SYSTEME DE DETECTION DE CHAMP MAGNETIQUE

(84) Benannte Vertragsstaaten:
**AT BE BG CH CY CZ DE DK EE ES FI FR GB GR HU IE IT LI LU MC NL PT RO SE SI SK TR**
Benannte Erstreckungsstaaten:
**AL LT LV MK**

(30) Priorität: **29.05.2002 DE 10224354**

(43) Veröffentlichungstag der Anmeldung:
**09.03.2005 Patentblatt 2005/10**

(73) Patentinhaber: **Landis+Gyr AG**
**6301 Zug (CH)**

(72) Erfinder: **PETR, Jan**
**CH-6317 Oberwil (CH)**

(74) Vertreter: **Lagler, Louis**
**Rentsch & Partner**
**Postfach 2441**
**8022 Zürich (CH)**

(56) Entgegenhaltungen:
**EP-A- 0 172 402**    **US-A- 3 219 909**
**US-A- 5 477 135**

**Beschreibung**

Die Erfindung betrifft eine Schaltungsanordnung und ein Verfahren zur Kompensation von Änderungen eines Übertragungsfaktors einer Magnetfeldsensoranordnung gemäss dem Oberbegriff des Anspruchs 1 beziehungsweise des Anspruchs 11.

Es ist bekannt, einen elektrischen Strom über das von ihm erzeugte Magnetfeld potentialfrei zu messen. Zur Ermittlung der Stärke des Magnetfelds dienen Magnetfeldsensoren, z. B. Hallsensoren, Magnetotransistoren und andere Halbleiterelemente, die ein zum Magnetfeld mehr oder weniger proportionales Ausgangssignal erzeugen. Um den Einfluss von Nichtlinearitäten und Änderungen des Übertragungsfaktors eines Manetfeldsensors zu unterbinden, werden spezielle Schaltungsanordnungen und mit ihnen durchführbare verfahren eingesetzt.

Die US 5,477,135 offenbart eine Strommessvorrichtung, umfassend einen Hallsensor und eine zweite Windung, die hinsichtlich eines magnetischen Flusses eines Magnetkreises in wirkverbindung stehen. Die Strommessvorrichtung ist selbstkalibrierend ausgebildet mittels einer digitalen Kompensation, umfassend eine Reihenschalung aus einem A/D-Wandler, einem Digitalregler und einem D/A-Wandler.

Die EP 0 172 402 A1 offenbart beispielsweise eine Schaltungsanordnung, mit der die Schwankungen des Ubertragungsfaktors eines Magnetfeldsensors kompensierbar sind. Hierfür ist vorgesehen, dass dem zu messenden Magnetfeld ein bekanntes Hilfsmagnetfeld überlagert wird, wobei beide Felder durch den Magnetfeldsensor erfasst werden. Ausgangsseitig des Magnetführt, dass der Anteil des Hilfsmagnetfeldes herausfilterbar ist. Dieser Signalanteil, der auf das Hilfsmagnetfeld zurückführbar ist, wird einem Korrelator übergeben, dessen zweiter Eingang eine Stromgeneratorspannung ist, die den für das Hilfsmagnetfeld erzeugenden Strom bereitsteht.

Ausgangsseitig dieses Korrelators ist ein Regler angeordnet, der ein Steuersignal für den mit Schwankungen behafteten Magnetfeldsensor bereitstellt, die auf diese Art kompensiert werden.

Als nachteilig kann dabei angesehen werden, dass die Genauigkeit und die Regelgeschwindigkeit dieser herkömmlichen Kompensationsschaltung begrenzt ist. Zudem ist die Kompensationsschaltung mindestens teilweise aus diskreten, analogen Bauelementen aufgebaut, was einen entsprechenden Installationsaufwand hinsichtlich Raum und Herstellung mit sich bringt.

Darstellung der Erfindung

Es ist deshalb Aufgabe der Erfindung, die bekannte Schaltungsanordnung dahingehend weiterzuentwickeln, dass die angestrebte Kompensation der Änderungen des Übertragungsfaktors einer Magnetfeldsensoranordnung genauer und schneller erfolgt und darüber hinaus eine Vereinfachung der Schaltung sich auch wirtschaftlicher niederschlägt. Darüber hinaus wird eine Optimierung des Regelbereiches eines der Kompensation dienenden Reglers angestrebt, was gleichzusetzen ist mit einer Verkleinerung des Regelbereiches; ein kleinerer Regelbereich bedeutet bekanntermassen eine wirksame Verbesserung des Signal/Rauschverhältnisses und somit eine deutliche Verbesserung des Kompensationsverhaltens der gesamten Schaltungsanordnung gegenüber dem zitierten Stand der Technik.

Des weiteren ist es Aufgabe der Erfindung, ein Verfahren bereitzustellen, mit dem eine präzise und schnelle Kompensation der Änderungen des Übertragungsfaktors einer Magnetfeldsensoranordnung durchgeführt werden kann. Auch mit dem erfindungsgemässen Verfahren wird eine Optimierung des Regelbereiches eines der Kompensation dienenden Reglers angestrebt, was einer Verkleinerung des Regelbereiches gleichkommt.

Die Lösung der der Erfindung zugrunde liegenden Aufgabe ist für die Schaltungsanordnung im Anspruch 1 angegeben. Diesen Erfindungsgedanken vorteilhaft weiterbildende Merkmale sind Gegenstand der Unteransprüche 2 bis 11.

Besonders herauszuheben bei der erfindungsgemässen Schaltungsanordnung zur Kompensation von Änderungen des Übertragungsfaktors einer Magnetfeldsensoranordnung ist die Ausbildung eines Regelkreises für diese Kompensation in Digitaltechnik - aufgebaut als integrierte Schaltung - wobei mittels der Regelsignalabweichung die Änderung des Übertragungsfaktors kompensiert wird. Vorteilhaft an dieser Schaltungsanordnung ist die höhere Genauigkeit und die höhere Regelgeschwindigkeit des Regelkreises mit einer Reihenschaltung aus einem A/D-Wandler, einem Digitalregler und einem D/A-Wandler; dabei erzielt man eine gegenüber dem Stand der Technik wesentlich genauere und schnellere Regelung, indem lediglich ein variabler Stellgrössenanteil über den Digitalregler geführt wird und erst danach ein konstanter Stellgrössenanteil zur eigentlichen - der Kompensation dienenden - Stellgrösse hinzuaddiert wird. Hierfür wird von dem dem Digitalregler zugeführten Istwertsignal entweder vor der A/D-Wandlung ein analoger individuell einstellbarer Sollwert oder nachher ein digitaler individuell einstellbarer Sollwert subtrahiert, sodass eine entsprechend kleinere Istwertsignalabweichung zum Digitalregler gelangt.

Bei der Subtraktion vor der A/D-Wandlung steht mit Vorteil ein individuell einstellbares, gedämpftes Hilfsgenerorsignal zur Verfügung, dass bereits für die Erzeugung des zusätzlichen Hilfsmagnetfeldes an der Magnetfeldsensoranordnung genutzt wird.

Für die Subtraktion hinter der A/D-Wandlung dient mit Vorteil ein individuell einstellbarer, digitaler Sollwert.

Mittels dieser beiden Ausgestaltungsrichtungen der Erfindung ist der Digitalregler in einem gegenüber dem Stand der Technik signifikant kleineren Regelbereich betreibbar, womit sein Signal/Rauschverhältnis wesentlich verbessert wird; der Digitalregler ist hierdurch nicht nur genauer sondern zeigt darüber hinaus eine wesentlich höhere Regelgeschwindigkeit.

Eine weitere Verbesserung des Signal/Rauschverhältnisses und der Regelgeschwindigkeit des Digitalreglers wird erreicht, indem im Neuzustand entweder das individuell einstellbare, gedämpfte Hilfsgeneratorsignal oder der individuell einstellbare Sollwert so eingestellt werden, dass der Digitalregler in der Mitte seines Regelbereiches eingestellt wird. Auf diese einfache Art kann eine Anpassung der gesamten Schaltungsanordnung zwecks Ausgleich einer Exemplarstreuung erfolgen. Diese erfindungsgemässen Schaltungsvarianten erlauben eine weitere Reduktion des Digitalregelbereiches und somit eine weitere Verbesserung hinsichtlich Genauigkeit und Regelgeschwindigkeit.

Die erfindungsgemässe Verwendung des Digitalreglers ermöglicht auch eine etwas ungenauere aber dafür besonders schnelle Ausregelung bei jedem Neustart der Schaltungsanordnung. In einem ersten Betriebszeitraum kann dem Digitalregler auf einfache, digitale Art ein erhöhter Übertragungsfaktor zugeführt werden, womit er innerhalb der ersten 5s sehr schnell und hinreicht genau ausregelt; anschliessend wird der Übertragungsfaktor für die im Dauerbetriebszustand geforderte schnelle und genaue Ausregelung reduziert.

Wie bereits oben erwähnt, wird dem variablen Stellgrössenanteil ausgangsseitig des Digitalreglers ein konstanter Stellgrössenanteil hinzuaddiert. Zwei vorteilhafte Ausgestaltungen finden hierbei wahlweise eine Umsetzung.

Eine erste - direkt kompensierende - Variante sieht vor, das Spannungssignal des variablen Stellgrössenanteils in einem Steuerglied in einen variablen Stellgrössenstromanteil zu transformieren, diesem einen konstanten Stellgrössenstromanteil hinzuzuaddieren und anschliessend unmittelbar den Magnetfeldsensoren zwecks Kompensation der Änderung ihres Obertragungsfaktors zuzuführen. Das ausgangsseitige Nutzsignal der Magnetfeldsensoranordnung ist bei der direkt kompensierenden Variante ein kompensiertes, analoges Signal das als solches genutzt werden kann oder einer A/D-Wandlung zuführbar ist.

Eine zweite - indirekt kompensierende - Variante sieht vor, dem Spannungssignal des variablen Stellgrössenanteils einen konstanten Stellgrössenanteil hinzuzuaddieren und anschliessend dem bzw. den der Magnetfeldsensoranordnung nachgeschalteten A/D-Wandlern als Referenzsignal zuzuführen, um eine Kompensation der Änderung des Übertragungsfaktors der Magnetfeldsensoren indirekt zu bewirken. Das ausgangsseitige Nutzsignal bei der indirekt kompensierenden Variante ist ein kompensiertes, digitales Signal hinter dem für die Kompensation genutzten A/D-Wandler.

Die weiteren, vorteilhaft die Erfindung hinsichtlich der Schaltungsanordnung weiterbildenden Merkmale, werden in der folgenden Beschreibung der Ausführungsbeispiele hervorgehoben.

Des weiteren ist die Lösung der der Erfindung zugrunde liegenden Aufgabe für das Verfahren zur Kompensation im Anspruch 12 angegeben. Diesen Erfindungsgedanken vorteilhaft weiterbildende Merkmale sind Gegenstand der Unteransprüche 13 bis 20.

Da die Vorteile hinsichtlich des Verfahrens unmittelbar mit denen der Schaltungsanordnung verknüpft sind, und diese bereits oben ihre Würdigung erfuhren, wird an dieser Stelle auf ihre Wiederholung verzichtet.

Alle Vorteile und Details der Erfindung hinsichtlich der Schaltungsanordnung und des Verfahren werden nachfolgend anhand der Ausführungsbeispiele näher erläutert. Es zeigen:

FIG. 1 ein Blockschaltbild einer erfindungsgemässen Schaltungsanordnung zur Kompensation der Änderungen des Übertragungsfaktors einer Magnetfeldsensoranordnung;

Fig. 2 eine Detailansicht eines Spannung-Stromwandlers der Schaltungsanordnung;

Fig. 3 eine Detailansicht eines Steuergliedes der Schaltungsanordnung, und

Fig. 4 eine Detailansicht eines weiteren Steuergliedes der Schaltungsanordnung.

Die erfindungsgemässe Schaltungsanordnung

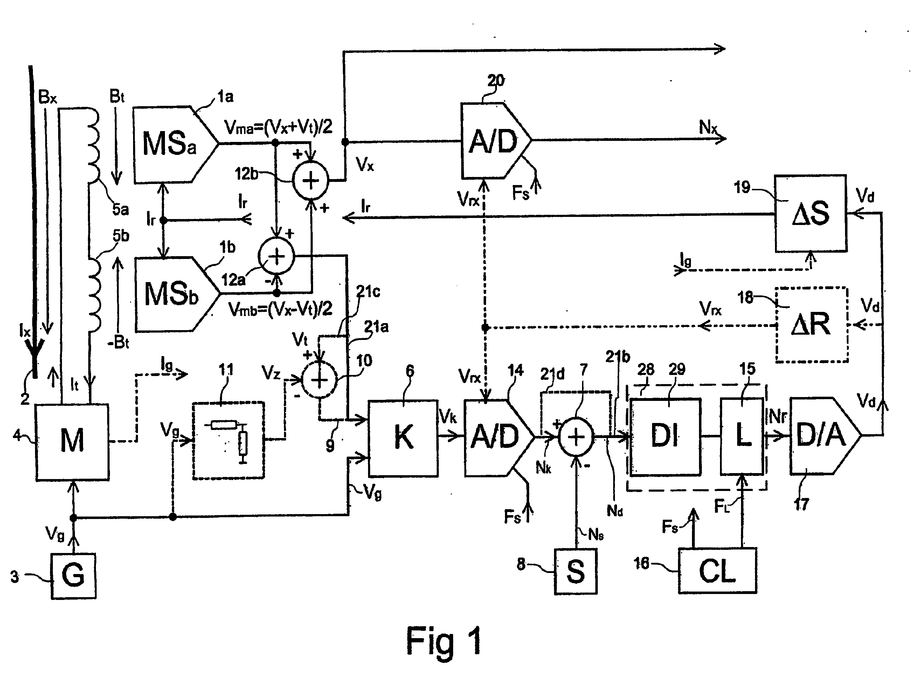

Figur 1 zeigt eine erfindungsgemässe Schaltungsanordnung mit einer Magnetfeldsensoranordnung, bestehend aus zwei Magnetfeldsensoren 1a, 1b (MSa, MSb). Diese Magnetfeldsensoren 1a, 1b sind beide mit einem Magnetfeld Bx eines zu erfassenden Messstroms Ix beaufschlagt, der durch eine Stromleitung 2 fliesst. Darüber hinaus werden die Magnetfeldsensoren 1a, 1b mit antiparallelen Hilfsmagnetfeldern Bt, -Bt gleichen Betrags beaufschlagt. Ein Hilfsstrom It erzeugt über eine entsprechende Hilfsspulenanordnung 5a, 5b diese Hilfsmagnetfelder Bt, -Bt. Die Hilfsspule 5a koppelt das durch den Hilfsstrom It erzeugte Hilfsmagnetfeld Bt an den ersten Magnetfeldsensor 1a und die Hilfsspule 5b beaufschlagt den zweiten Magnetfeldsensor 1b mit einem ebenfalls durch denselben Hilfsstrom It erzeugten Hilfsmagnetfeld -Bt, dass gleich gross ist wie das Hilfsmagnetfeld Bt aber antiparallel hierzu.

Der die Hilfsmagnetfelder Bt, -Bt erzeugende Hilfsstrom It wird mittels eines Spannung-Stromwandlers 4 (M) erzeugt. Dieser Spannung-Stromwandler 4 generiert den Hilfsstrom It in Abhängigkeit einer ihm aus einem Hilfssignalgenerator 3 (G) zugeführten Spannung Vg.

Ausgangsseitig sind die Magnetfeldsensoren 1a, 1b mit einem ersten Summenglied 12a verbunden, das selbst ausgangsseitig über eine Verbindung 21a mit einem Korrelator 6 verbunden ist. An seinem zweiten Eingang weist der Korrelator 6 eine Verbindung mit dem Hilfssignalgenerator 3 auf, wobei hier dasselbe Spannungssignal Vg, das bereits bei der Erzeugung des Hilfsstroms It Verwendung findet, anliegt.

In Reihenschaltung folgt ausgangsseitig des Korrelators 6 ein erster A/D-Wandler 14, ein Digitalregler 28 und ein D/A-Wandler 17. Zwecks Sollwertvorgabe ist in einer ersten Variante zwischen dem ersten A/D-Wandler 14 und dem Digitalregler 28 ein Sollwertgeber 8 (S) mittels einer Verbindung 21b und eines weiteren Summenglieds 7 angeordnet, dass im folgenden viertes Summenglied 7 genannt wird.

Erfindungsgemäss dient das Ausgangssignal Vd des D/A-Wandlers 17 als variabler Stellgrössenanteil der Kompensation der Änderungen des Übertragungsfaktors der Magnetfeldsensoren 1a, 1b. Ohne diesen Erfindungsgedanken zu verlassen, sind schaltungstechnisch hinter dem D/A-Wandler zwei Varianten ausführbar. Eine erste Variante ist charakterisierend mit "Direkter Kompensation" bezeichnet; eine weitere Variante wird im Folgenden beschreibend "Indirekte Kompensation" genannt.

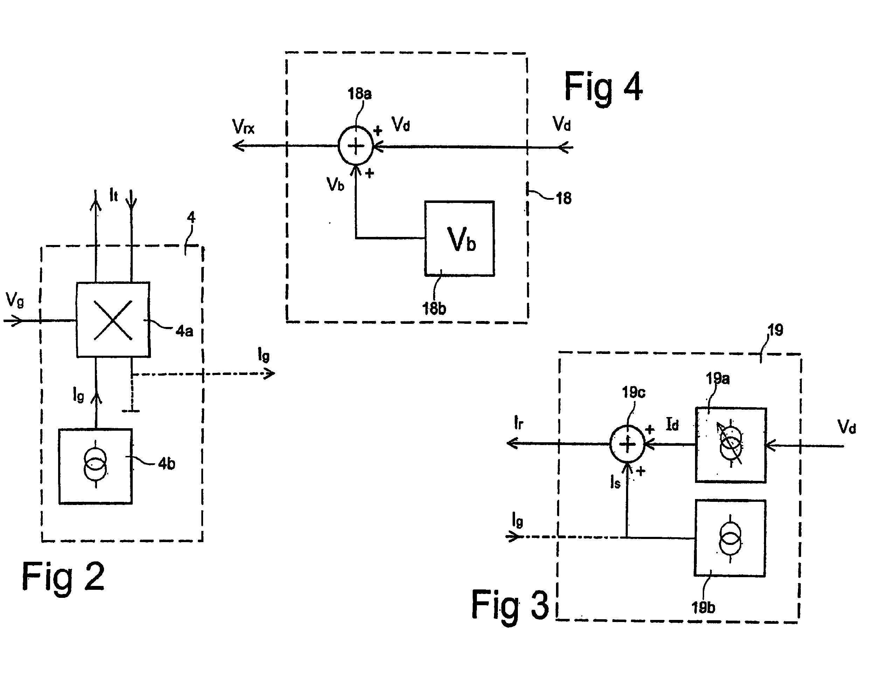

Bei der direkten Kompensation ist der D/A-Wandler 17 über ein erstes Steuerglied 19 (ΔS) mit den Magnetfeldsensoren 1a, 1b verbunden, und zwar mit dem Steuersignaleingang dieser Sensoren. Das Steuerglied 19 ist detaillierter in Fig. 3 dargestellt. Hier ist ersichtlich, dass das Ausgangssignal Vd des D/A-Wandlers einer spannungsgesteuerten Stromquelle 19a zugeführt wird. Dem ausgangsseitigen Stromsignal Id der Stromquelle 19a wird ein konstanter Stromanteil Is mittels eines sechsten Summenglieds 19c hinzuaddiert. Dabei kann dieser konstante Stromanteil Is aus einer Hilfsstromquelle 19b zugeführt werden, oder das sechste Summenglied 19c ist mit einem Stromausgangssignal Ig des Spannung-Stromwandlers 4 verbunden, wie die Fig. 2 erhellt. Der Spannung-Stromwandler 4 umfasst eine spannungsgesteuerte Stromquelle 4b und eine nachgeschaltete Funktionsschaltung 4a, der dieser Hilfsstrom Ig als konstanter Stromanteil entnehmbar ist.

Bei der weiteren erfindungsgemässen Variante, die indirekte Kompensation, ist vorgesehen, dass der D/A-Wandler 17 mit einem zweiten Steuerglied 18 verbunden ist. Dieses umfasst, wie Fig. 4 zeigt, ein drittes Summenglied 18a, mit welchem eine Hilfsspannungsquelle 18b eine konstante Hilfsspannung Vb zu dem Ausgangssignal Vd des D/A-Wandlers führt. Das Summensignal Vrx des dritten Summenglieds 18a ist mit dem ersten A/D-Wandler und mit einem weiteren, zweiten A/D-Wandler 20 verbunden, der ausgangsseitig der Magnetfeldsensoren 1a, 1b mit einem zweiten Summenglied 12b verbunden ist. Dieses zweite Summenglied 12b dient der Bestimmung des nur durch den Messstrom Ix erzeugten Anteils Vx des Ausgangssignals der Magnetfelssensoren 1a, 1b, und anschliessend wird dieser Ausgangssignalanteil Vx in dem zweiten A/D-Wandler 20 digitalisiert. Parallel zu der A/D-Wandlung von Vx ist dieses Signal auch analog weiter verfügbar.

Die weiter oben bereits erläuterte, digitale Sollwertvorgabe mittels Sollwert 8 und viertem Summenglied 7 für den Regelkreis kann optional auch ersetzt werden durch eine analoge Sollwertvorgabe, und zwar mittels eines weiteren, fünften Summenglieds 10 mit vorgeschaltetem Dämpfungsglied 11, dass mit dem Hilfsspannungsgenerator 3 verbunden ist. Das fünfte Summenglied 10 ist zwischen dem ersten Summenglied 12a und dem Korrelator 6 angeordnet. Bei Verwendung dieser Sollwertvorgabe ist die Verbindung 21a unterbrochen und 21c verbindet das erste Summenglied 12a mit dem fünften Summenglied 10. Darüber hinaus ist die Verbindung 21b zwischen viertem Summenglied 7 und dem Digitalregler 28 unterbrochen, und den ersten A/D-Wandler 14 verbindet die Leitung 21d mit dem Digitalregler 28.

Vorzugweise ist der erste A/D-Wandler 14 als Σ/Δ-Wandler ausgebildet; er sollte möglichst offsetarm sein (low offset A/D converter), wobei an ihn keine hohen Anforderungen bezüglich seiner Verarbeitungsgeschwindigkeit gestellt werden. Umgekehrt verhält es sich bei dem zweiten A/D-Wandler 20, den aufgrund nachfolgender Berechnungen ein Offset weniger stört, der aber vergleichsweise besonders schnell sein muss.

Erfindungswesentlich ist, dass die oben erläuterte Schaltungsanordnung vollständig als integrierte Schaltungsanordnung ausgebildet ist. Erst die Kombination aus beschriebener Sollwertvorgabe - in beiden Ausgestaltungen Ns bzw. Vz - und der Stellgrössenglieder 18 oder 19 mit einer digitalen Regelung 28 in integrierter Schaltung führt zu einer bisher nicht bekannten, wesentlichen Verbesserung der Regelgeschwindigkeit und der Regelgenauigkeit bei der Kompensation von Änderungen der Übertragungsfaktors von Magnetfeldsensoren 1a, 1b, insbesondere bei der verrechnungsrelevanten Erfassung von elektrischen Strömen in der Elektrizitätszählertechnik. Darüber hinaus ist diese erfindungsgemässe, integrierte Schaltung wirtschaftlich besonders vorteilhaft und auch hinsichtlich einer Exemplarstreuung besonders einfach handhabbar, was im folgenden bezüglich der Funktionsweise der gesamten integrierten Schaltungsanordnung intensiver beleuchtet werden wird.

Vorab soll noch vermerkt sein, dass die Magnetfeldsensoren beispielsweise als Hallgeneratoren oder Magnetotransistoren ausgebildet sind.

Funktionsbeschreibung der erfindungsgemässen Schaltungsanordnung

Die erfindungsgemässe Schaltungsanordnung dient der Kompensation von Änderungen der Übertragungsfaktoren von Magnetfeldsensoren. Diese Änderungen basieren auf Nichtlinearitäten, die durch Temperaturschwankungen und Alterung hervorgerufen werden können. Darüber hinaus ist von Bedeutung, dass einer Exemplarstreuung verschiedener Schaltungsanordnungen des erfindungsgemässen Typs auf einfachste Weise begegnet werden kann.

Die Magnetfeldsensoren 1a, 1b erfassen das von einem zu messenden Strom Ix erzeugte Magnetfeld Bx. Diesem Magnetfeld ist ein paralleles Hilfsmagnetfeld Bt bzw. ein antiparalleles Hilfsmagnetfeld -Bt überlagert, und zwar so, dass Bt von dem Magnetfeldsensor 1a und -Bt von dem Magnetfeldsensor 1b erfasst wird. Demnach verkleinert das Hilfsmagnetfeld für einen Magnetfeldsensor das Feld um den Betrag von Bt, während für den anderen Magnetfeldsensor das Feld verstärkt wird um den Betrag von Bt.

Die Magnetfeldsensoren 1a und 1b sind so ausgelegt, dass sich ihre Ausgangssignale Vma und Vmb wie folgt ergeben:

Für den Magnetfeldsensor 1a, Vma = 0.5 * (Vx + Vt) und Vmb = 0.5 * (Vx - Vt) für den Magnetfeldsensor 1b.

Diese Ausgangssignale der Magnetfeldsensoren Vma, Vmb werden mittels eines ersten Summenglieds 12a wie folgt verarbeitet:

$$Vma - Vmb = 0.5 * (Vx + Vt) - 0.5 * (Vx - Vt) = Vt,$$

und es ergibt sich ausgangsseitig des ersten Summenglieds 12a der Anteil Vt der ausschliesslich durch den Hilfssignalstrom It erzeugt wird.

Ein weiteres, zweites Summenglied 12b hinter den Magnetfeldsensoren 1a, 1b führt zu dem Ausgangssignal Vx mit:

$$Vma + Vmb = 0.5 * (Vx + Vt) + 0.5 * (Vx - Vt) = Vx.$$

Dieses Ausgangssignal Vx stellt den Messsignalanteil an Vma bzw. Vmb dar, und basiert ausschliesslich auf dem durch den Messstrom Ix erzeugten Magnetfeld Bx.

Dem Regelkreis zur Kompensation folgend wird Vt über die Verbindung 21a dem Korrelator 6 zugeführt, der als weiteres Eingangssignal die Hilfsspannung Vg des Hilfssignalgenerators 3 aufweist. Das Korrelatorausgangssignal Vk wird der A/D-Wandlung 14 zugeführt und anschliessend als digitalisiertes Signal Nk über die Verbindung 21b einer Sollwertvorgabe Ns an einem vierten Summenglied 7 zugeführt. Mit dieser Sollwertvorgabe Ns wird dem Digitalregler ein Signal Nd = Nk - Ns zugeführt und der Digitalregler derart betrieben, dass sich als Ausgangssignal des nachgeschalteten D/A-Wandlers 17 lediglich ein variabler Stellgrössenanteil Vd ergibt, der massgeblich kleiner ist, als die gesamte zur Kompensation verwendete Stellgrösse, bestehend aus dem variablen (Vd bzw. Id) und einem hinzuzuaddierenden konstanten Stellgrössenanteil (Vb bzw. Is).

Auf diese Art ist der Digitalregler 28 in einem gegenüber dem Stand der Technik signifikant kleineren Regelbereich betreibar, womit sein Signal/Rauschverhältnis wesentlich verbessert wird; der Digitalregler ist hierdurch nicht nur genauer sondern zeigt darüber hinaus eine wesentlich höhere Regelgeschwindigkeit.

Entsprechend dieser digitalen Sollwertvorgabe Ns ist ebenfalls eine analoge Sollwertvorgabe vor dem Korrelator 6 ersetzend wählbar. Hierfür gilt, dass die Verbindungen 21a und 21b unterbrochen sind, während die Verbindungen 21c und 21d geschlossen sind, wobei der Digitalregler in seiner Funktionsweise identisch betrieben wird, wie bei der digitalen Sollwertvorgabe Ns.

Beiden Sollwertvorgaben ist gemeinsam, dass sie individuell einstellbar sind. Dies führt zu dem weiteren Vorteil, dass nämlich im Neuzustand entweder das individuell einstellbare, gedämpfte Hilfsgeneratorsignal, kurz, die Dämpfungsspannung Vz, oder der individuell einstellbare Sollwert Ns so eingestellt werden, dass der Digitalregler 28 in der Mitte seines Regelbereiches eingestellt wird. Auf diese einfache Art kann eine Anpassung der gesamten Schaltungsanordnung zwecks Ausgleich einer Exemplarstreuung verschiedener Schaltungsanordnungen gleichen Typs erfolgen. Diese erfindungsgemässen individuell einstellbaren Sollwertvorgaben Vz bzw. Ns erlauben somit eine weitere Reduktion des Digitalregelbereiches und stellen eine weitere Verbesserung hinsichtlich Genauigkeit und Regelgeschwindigkeit dar.

Ausgangsseitig des D/A-Wandlers erfolgt eine "Direkte Kompensation" oder eine "Indirekte Kompensation" der Änderung der Übertragungsfaktoren der Magnetfeldsensoren 1a, 1b unter Berücksichtigung des variablen Stellgrössenanteils Vd.

Die direkte Kompensation

Bei der direkten Kompensation wird der variable Stellgrössenanteil Vd in dem ersten Steuerglied 19 mittels der spannungsgesteuerten Stromquelle 19a in einen variablen Stellgrössenstromanteil Id umgeformt. Anschliessend wird diesem variablen Stellgrössenstromanteil Id ein konstanter Stellgrössenanteil Is hinzuaddiert. Das Ergebnis ist ein Steuerstromsignal Ir für die Magnetfeldsensoren 1a, 1b, zwecks direkter Einflussnahme ihrer Übertragungsfunktion. Der konstante Stellgrössenstromanteil Is kann wahlweise der Hilfsstromquelle 19 entnommen werden oder dem Spannung-Stromwandler 4. Dieser Spannung-Stromwandler umfasst eine spannungsgesteuerte Stromquelle 4b und eine Funktionsschaltung 4a, der der konstante Stellgrössenstromanteil Ig entnehmbar ist.

Die indirekt Kompensation

Bei der indirekten Kompensation wird dem variablen Stellgrössenanteil Vd in einem zweiten Steuerglied 18 unmittelbar ein konstanter Stellgrössenanteil Vb mittels drittem Summenglied 18a hinzuaddiert. Die Stellgrösse Vd + Vb wird dann den beiden A/D-Wandlern 14 und 20 als Steuersignal Vrx zugeführt, womit die indirekte Kompensation der Änderung der Obertragungsfunktion der Magnetfeldsensoren 1a, 1b erfolgt, nämlich über die Manipulation der ihnen nachgeschalteten A/D-Wandler.

Für den gesamten Regelkreis gilt in jedem Fall im ausgeregelten Zustand:
Die Dämpfungsspannung Vz ist gleich gross wie der Hilfssignalanteil Vt bzw. das digitalisierte Korrelatorsignal Nk ist gleich gross wie der digitale Sollwert Ns.

Über die bereits erfindungsgemäss erzielten Vorteile hinaus, weist die Schaltungsanordnung einen weiteren Vorteil im Einschaltmoment auf. Mit einem Kompromiss zugunsten der Regelgeschwindigkeit und zuungunsten der Regelgenauigkeit wird der Übertragungsfaktor des Digitalreglers 28 in einer Einschaltphase von 5s deutlich erhöht, um eine schnelle Annäherung der Regelung zu bewirken; anschliessend erfolgt dann die Rücksetzung des Übertragungsfaktors des Digitalreglers 28 für Dauerbetrieb. Diese Massnahme ist wegen der digitalen Einflussnahme auf dem Digitalregler besonders einfach ausführbar.

Der Digitalregler selbst umfasst einen digitalen Integrator 29 und ein Auffang-Flip-Flop 15 (Latch, L). Zeitlich gesteuert wird die gesamte Schaltungsanordnung über einen Taktgeber 16 (CL) der Taktsignale Fs -für die A/D-Wandler 14 und 20- und FI -für das Auffang-Flip-Flop 15- erzeugt und abgibt.

**Patentansprüche**

1. Schaltungsanordnung zur Kompensation von Änderungen eines Übertragungsfaktors einer Magnetfeldsensoranordnung (1a, 1b),

- mit einer an einem Hilfssignalgenerator (3) mit nachgeschaltetem Spannung-Stromwandler (4) angeschlossenen Spulenanordnung (5a, 5b) zur Erzeugung eines einem zu messenden Magnetfeld (Bx) überlagerten Hilfsmagnetfelds (Bt, -Bt), wobei ein erstes Summenglied (12a) vorhanden ist zur Bestimmung eines allein durch das Hilfsmagnetfeld (Bt) erzeugten Anteils (Vt) einer Ausgangsspannung (Vma, Vmb) der Magnetfeldsensoranordnung (1a, 1b),
- mit einem Korrelator (6), der eingangsseitig zum einen mit dem Ausgang des ersten Summenglieds (12a) verbunden ist, und der zum anderen mit einem spannungssignalausgang (Vg) des Hilfssignalgenerators (3) verbunden ist,

**dadurch gekennzeichnet,**
**dass** die Schaltungsanordnung als integrierte Schaltung ausgebildet ist,
**dass** ausgangsseitig des Korrelators (6) in einer Reihenschaltung ein erster A/D-Wandler (14), ein Digitalregler (28) und ein D/A-Wandler (17) angeordnet sind,
**dass** mit einem ausgangsseitig dieser Reihenschaltung (14, 28, 17) erzeugten, variablen stellgrösseanteil (Vd) und einem hierzu addierten konstanten Stellgrössenanteil (Vb, Is) die Änderung des übertragungsfaktors der Magnetfeldsensoranordnung (1a, 1b) kompensierbar ist,
**dass** ein zweites Summenglied (12b) vorhanden ist zur Bestimmung eines allein durch das zu messende Magnetfeld (Bx) erzeugten Anteils (Vx) der Ausgangsspannung (Vma, Vmb) der Magnetfeldsensoranordnung (1a, 1b), und
**dass** ausgangsseitig des zweiten Summenglieds (12b) ein weiterer A/D-Wandler (20) angeordnet ist, wobei dessen Übertragungsfunktion und die Übertragungsfunktion des ersten A/D-Wandlers (14) mittels der Summe (Vrx) aus dem variablen Stellgrössenanteil (Vd) und dem konstanten Stellgrössenanteil (Vb) beeinflubbar ist.

2. Schaltungsanordnung nach Anspruch 1, **dadurch gekennzeichnet, dass** der variable Stellgrössenanteil (Vd) über ein erstes Steuerglied (19) der Magnetfeldsensoranordnung (1a, 1b) zuführbar ist.

3. Schaltungsanordnung nach Anspruch 2, **dadurch gekennzeichnet, dass** das erste Steuerglied (19) in Reihenschaltung eine spannungsgesteuerte Stromquelle (19a) zum Erzeugen eines variablen Stellgrössenstromanteils (Id) in Abhängigkeit des variablen Stellgrössenanteils (Vd) und ein sechstes Summenglied (19c) umfasst, wobei mittels dieses sechsten Summenglieds (19c) dem variablen Stellgrössenstromanteil (Id) ein konstanter Stellgrössenstromanteil (Is) hinzuaddierbar ist.

4. Schaltungsanordnung nach Anspruch 3, **dadurch gekennzeichnet, dass** das sechste Summenglied (19c) mit einer Hilfsstromquelle (19b) zwecks Lieferung des konstanten Stellgrössenstromanteil (Is) verbunden ist.

5. Schaltungsanordnung nach Anspruch 3, **dadurch gekennzeichnet, dass** das sechste Summenglied (19c) mit dem Spannung-Stromgenerator (4) zwecks Lieferung des konstanten stellgrössenstromanteil (Is) verbunden ist.

6. Schaltungsanordnung nach einem der Ansprüche 1 bis 5, **dadurch gekennzeichnet, dass** ein zweites Steuerglied (18) zwischen dem D/A-Wandler (17) und dem ersten (14) bzw. dem weiteren A/D-Wandler (20) vorgesehen ist, welches eine Referenzspannung (Vrx) für den ersten (14) bzw. den weiteren A/D-wandler (20) bereitstellt.

7. Schaltungsanordnung einem der Ansprüche 1 bis 6, **dadurch gekennzeichnet, dass** das zweite Steuerglied (18) eine Hilfsspannungsquelle (18b) mit einer konstanten Hilfsspannung (Vb) und ein drittes Summenglied (18a) zum Addieren des variablen Stellgrössenanteils (Vd) und der Hilfsspannung (Vb) umfasst.

8. Schaltungsanordnung nach einem der Ansprüche 1 bis 7, **dadurch gekennzeichnet, dass** zwischen dem ersten A/D-Wandler (14) und dem Digitalregler (29) ein viertes Summenglieds (7) angeordnet ist, welches eingangsseitig mit einem Sollwertgeber (8) und dem ersten A/D-Wandler (14) verbunden ist und welches ausgangsseitig mit dem Digitalregler (28) verbunden ist.

9. Schaltungsanordnung nach einem der Ansprüche 1 bis 7, **dadurch gekennzeichnet, dass** zwischen dem ersten Summenglied (12a) und dem Korrelator (6) ein fünftes Summenglied (10) angeordnet ist, wobei der Ausgang des ersten Summenglieds (12a) mit einem Eingang des fünften Summenglieds (10) verbunden ist und wobei ein weiterer Eingang des fünften Summengliedes (10) über ein Dämpfungsglied (11) mit dem Spannungssignalausgang (Vg) des Hilfssignalgenerators (3) verbunden ist.

10. Schaltungsanordnung nach einem der vorhergehenden Ansprüchen, **dadurch gekennzeichnet, dass** der erste A/D-Wandler als $\Sigma/\Delta$-Modulator ausgebildet ist.

11. Verfahren zur Kompensation von Änderungen eines Übertragungsfaktors einer Magnetfeldsensoranordnung (1a, 1b),

   - wobei mit einer an einem Hilfssignalgenerator (3) mit nachgeschaltetem Spannungsstromwandler (4) angeschlossenen Spulenanordnung (5a, 5b) ein einem zu messenden Magnetfeld (Bx) überlagertes Hilfsmagnetfeld (Bt) erzeugt wird,
   - wobei mittels eines ersten summenglieds (12a) ein allein durch das Hilfsmagnetfeld (Bt) erzeugter Anteil (Vt) einer Ausgangsspannung (Vma, Vmb) der Magnetfeldsensoranordnung (1a, 1b) ermittelt wird,
   - wobei dieser allein durch das Hilfsmagnetfeld (Bt) erzeugte Anteil (Vt) der Ausgangsspannung (Vma, Vmb) auf einen ersten Eingang eines Korrelators (6) geführt ist, und wobei ein Spannungssignal (Vg) des Hilfssignalgenerator (3) auf einen zweiten Eingang des Korrelators (6) geführt ist,

   dass ein Ausgangssignal (Vk) des Korrelators (6) in einer Reihenschaltung einem A/D-Wandler (14), einem Digitalregler (28) und einem D/A-Wandler (17) zugeführt ist,
   dass mit einem ausgangsseitig dieser Reihenschaltung (14, 28, 17) erzeugten, variablen Stellgrösseanteil (Vd, Id) und einem hierzu addierten konstanten Stellgrössenanteil (Vb, Is) die Änderung des Übertragungsfaktors der Magnetfeldsensoranordnung (1a, 1b) kompensiert wird,
   dass mittels eines zweiten Summenglieds (12b) ein allein durch das zu messende Magnetfeld (Bx) erzeugter Anteil (Vx) der Ausgangsspannung (Vma, Vmb) der Magnetfeldsensoranordnung (1a, 1b) ermittelt wird,
   dass ausgangsseitig des zweiten Summengliedes (12b) ein weiterer A/D-Wandler (20) angeordnet ist, und
   dass zwecks Kompensation der Änderung des Übertragungsfaktors der Magnetfeldsensoranordnung (1a, 1b), der jeweilige Übertragungsfaktor des ersten (14) und des zweiten A/D-Wandlers (20) mit dem ausgangsseitig der Reihenschaltung (14, 28, 17) erzeugten, variablen Stellgrösseanteil (Vd) und dem hierzu addierten konstanten Stellgrössenanteil (Vb) eingestellt wird.

**12.** Verfahren nach Anspruch 11, **dadurch gekennzeichnet, dass** der variable Stellgrössenanteil (Vd) über ein erstes Steuerglied (19) der Magnetfeldsensoranordnung (1a, 1b) zugeführt wird.

**13.** Verfahren nach Anspruch 12, **dadurch gekennzeichnet, dass** das erste Steuerglied (19) in Reihenschaltung eine spannungsgesteuerte Stromquelle (19a) zum Erzeugen eines variablen Stellgrössenstromanteils (Id) in Abhängigkeit des variablen Stellgrässenanteils (Vd) und ein sechstes Summenglied (19c) umfasst, wobei mittels dieses sechsten Summenglieds (19c) zu dem variablen Stellgrössenstromanteil (Id) ein konstanter Stellgrössenstromanteil (Is) addiert wird.

**14.** Verfahren nach Anspruch 13, **dadurch gekennzeichnet, dass** (19b) der konstante Stellgrössenstromanteil (Is) zugeführt wird.

**15.** Verfahren nach Anspruch 13, **dadurch gekennzeichnet, dass** dem sechsten Summenglied (19c) mittels des Spannung-Stromwandlers (4) der konstante Stellgrössenstromanteil (Is) zugeführt wird.

**16.** Verfahren nach nach einem der Ansprüche 11 bis 15, **dadurch gekennzeichnet,**
**dass** ausgangsseitig der Reihenschaltung (14, 28, 17) ein zweites Steuerglied (18) angeordnet ist, in welchem dem variablen Stellgrössenanteil (Vd) der konstante Stellgrössenanteil (Vb) einer Hilfsspannungsquelle (18b) mittels eines dritten Summenglieds (18a) hinzuaddiert wird.

**17.** Verfahren nach einem der Ansprüche 11 bis 16, **dadurch gekennzeichnet,**
**dass** dem Ausgangssignal des ersten A/D-Wandlers (14) mittels einem vierten Summenglied (7) ein einstellbarer Sollwert (Ns) hinzuaddiert wird, und
**dass** mittels des individuell einstellbaren Sollwerts (Ns) im Neuzustand der Regelbereich des Digitalreglers (28) auf dessen Mittelwert eingestellt wird zwecks Berücksichtigung einer Exemplarstreuung der Schaltungsanordnung.

**18.** Verfahren nach einem der Ansprüche 11 bis 17, **dadurch gekennzeichnet,**
**dass** dem Ausgangssignal (Vt) des ersten Summenglieds (12a) mittels einem fünften Summenglied (10) eine individuell einstellbare Dämpfungsspannung (Vz) hinzuaddiert wird, die aus dem über ein Dämpfungsglied (11) geführten Spannungssignal (Vg) des Hilfssignalgenerators (3) gebildet wird, und
**dass** mittels der individuell einstellbaren Dämpfungsspannung (Vz) im Neuzustand der Regelbereich des Digitalreglers (28) auf dessen Mittelwert eingestellt wird zwecks Berücksichtigung einer Exemplarstreuung der Schaltungsanordnung.

**Claims**

**1.** A circuit arrangement to compensate for variations of a transmission factor of a magnetic field sensor arrangement (1a, 1b),

- comprising a coil arrangement (5a, 5b) connected to an auxiliary signal generator (3) with a subsequently connected voltage-current converter (4) to generate an auxiliary magnetic field (Bt, -Bt) superimposed on a magnetic field (Bx) to be measured,
wherein a first sum member (12a) is provided to determine a fraction (Vt) of an output voltage (Vma, Vmb) of the magnetic field arrangement (1a, 1b) produced solely by the auxiliary magnetic field (Bt),
- comprising a correlator (6) which is connected on the input side firstly to the output of the first sum member (12a), and which is secondly connected to a voltage signal output (Vg) of the auxiliary signal generator (3),

**characterised in**
**that** the circuit arrangement is constructed as an integrated circuit,
**that** on the output side of the correlator (6) a first A/D converter (14), a digital regulator (28) and a D/A converter (17) are arranged in a series circuit,
**that** the variation in the transmission factor of the magnetic field sensor arrangement (1a, 1b) can be compensated using a variable control-variable fraction (Vd) generated on the output side of this series circuit (14, 28, 17) and a constant control-variable fraction (Vb, Is) added hereto,
**that** a second sum member (12b) is provided to determine a fraction (Vx) of the output voltage (Vma, Vmb) of the magnetic field sensor arrangement (1a, 1b) generated solely by the magnetic field (Bx) to be measured, and
**that** a further A/D converter (20) is arranged on the output side of the second sum member (12b) wherein its transmission function and the transmission function of the first A/D converter (14) can be influenced by means of the sum (Vrx) of the variable control-variable fraction (Vd) and the constant control-variable fraction (Vb).

2. The circuit arrangement according to claim 1, **characterised in that** the variable control-variable fraction (Vd) can be supplied to the magnetic field sensor arrangement (1a, 1b) by means of a first control member (19).

3. The circuit arrangement according to claim 2, **characterised in that** the first control member (19) comprises, in a series circuit, a voltage-controlled current source (19a) to produce a variable control-variable current fraction (Id) as a function of the variable control-variable fraction (Vd) and a sixth sum member (19c), wherein a constant control-variable current fraction (Is) is added to the variable control-variable current fraction (Id) by means of this sixth sum member (19c).

4. The circuit arrangement according to claim 3, **characterised in that** the sixth sum member (19c) is connected to an auxiliary current source (19b) to supply the constant control-variable current fraction (Is).

5. The circuit arrangement according to claim 3, **characterised in that** the sixth sum member (19c) is connected to the voltage-current generator (4) to supply the constant control-variable current fraction (Is).

6. The circuit arrangement according to any one of claims 1 to 5, **characterised in that** a second control member (18) is provided between the D/A converter (17) and the first (14) or the further A/D converter (20) which provides a reference voltage (Vrx) for the first (14) or the further A/D converter (20).

7. The circuit arrangement according to any one of claims 1 to 6, **characterised in that** the second control member (18) comprises an auxiliary voltage source (18b) with a constant auxiliary voltage (Vb) and a third sum member (18a) for adding the variable control-variable fraction (Vd) and the auxiliary voltage (Vb).

8. The circuit arrangement according to any one of claims 1 to 7, **characterised in that** located between the first A/D converter (14) and the digital regulator (29) is a fourth sum member (7) which is connected on the input side to a set-point transmitter (8) and the first A/D converter (14) and which is connected on the output side to the digital regulator (28).

9. The circuit arrangement according to any one of claims 1 to 7, **characterised in that** a fifth sum member (10) is arranged between the first sum member (12a) and the correlator (6), wherein the output of the first sum member (12a) is connected to the input of the fifth sum member (10) and wherein a further input of the fifth sum member (10) is connected to the voltage signal output (Vg) of the auxiliary signal generator (3) by means of a damping member (11).

10. The circuit arrangement according to any one of the preceding claims, **characterised in that** the first A/D converter is constructed as a $\Sigma/\Delta$ modulator.

11. A method for compensating for variations of a transmission factor of a magnetic field sensor arrangement (1a, 1b),

   - wherein an auxiliary magnetic field (Bt) superimposed on a magnetic field (Bx) to be measured is generated using a coil arrangement (5a, 5b) connected to an auxiliary signal generator (3) with a subsequently connected voltage-current converter (4),
   - wherein an output voltage (Vma, Vmb) of the magnetic field sensor arrangement (1a, 1b) produced solely by the auxiliary magnetic field (Bt) is determined by means of a first sum member (12a),
   - wherein this fraction (Vt) of the output voltage (Vma, Vmb) generated merely by the auxiliary magnetic field (Bt) is guided to a first input of a correlator (6) and wherein a voltage signal (Vg) of the auxiliary signal generator (3) is guided to a second input of the correlator (6),

   **characterised in**
   **that** an output signal (Vk) of the correlator (6) is supplied in a series circuit to an A/D converter (14), a digital regulator (28) and a D/A converter (17),
   **that** the variation in the transmission factor of the magnetic field sensor arrangement (1a, 1b) can be compensated using a variable control-variable fraction (Vd, Id) generated on the output side of this series circuit (14, 28, 17),
   **that** a second sum member (12b) is used to determine a fraction (Vx) of the output voltage (Vma, Vmb) of the magnetic field sensor arrangement (1a, 1b) generated solely by the magnetic field (Bx) to be measured, that a further A/D converter (20) is arranged on the output side of the second sum member (12b) and **that** in order to compensate for the variation in the transmission factor of the magnetic field sensor arrangement (1a, 1b), the respective transmission function of the first (14) and the second A/D converter (20) is adjusted by means of the variable control-variable fraction (Vd) generated on the output side of the series circuit (14, 28, 17) and the constant control-variable fraction (Vb) added hereto.

12. The method according to claim 11, **characterised in that** the variable control-variable fraction (Vd) is supplied to the magnetic field sensor arrangement (1a, 1b) by means of a first control member (19).

13. The method according to claim 12, **characterised in that** the first control member (19) comprises, in a series circuit, a voltage-controlled current source (19a) to produce a variable control-variable current fraction (Id) as a function of the variable control-variable fraction (Vd) and a sixth sum member (19c), wherein a constant control-variable current fraction (Is) is added to the variable control-variable current fraction (Id) by means of this sixth sum member (19c).

14. The method according to claim 13, **characterised in that** the constant control-variable current fraction (Is) is supplied to the sixth sum member (19c) by means of an auxiliary current source (19b).

15. The method according to claim 13, **characterised in that** the constant control-variable current fraction (Is) is supplied to the sixth sum member (19c) by means of the voltage-current generator (4).

16. The method according to any one of claims 11 to 15, **characterised in that** a second control member (18) is provided on the output side of the series circuit (14, 28, 17) in which the constant control-variable fraction (Vb) of an auxiliary voltage source (18b) is added to the variable control-variable fraction (Vd) by means of a third sum member (18a).

17. The circuit arrangement according to any one of claims 11 to 16, **characterised in that** an adjustable desired value (Ns) is added to the output signal of the first A/D converter (14) by means of a fourth sum member (7) and that by means of the individually adjustable desired value (Ns) in the new state the regulating range of the digital regulator (28) is adjusted to its average value to allow for series tolerances of the circuit arrangement.

18. The circuit arrangement according to any one of claims 11 to 17, **characterised in that** an individually adjustable damping voltage (Vz) is added to the output signal (Vt) of the first sum member (12a) by means of a fifth sum member (10), which is formed from the voltage signal (Vg) of the auxiliary signal generator (3 guided via a damping member (11) and that by means of the individually adjustable desired value (Ns) in the new state the regulating range of the digital regulator (28) is adjusted to its average value to allow for series tolerances of the circuit arrangement.

## Revendications

1. Système de circuit pour la compensation de modifications d'un facteur de transmission d'un système de capteur de champ magnétique (1a, 1b),

   - comprenant un système de bobine (5a, 5b) raccordé à un générateur de signaux auxiliaires (3) avec un transformateur de tension-courant branché en aval (4), pour la génération d'un champ magnétique auxiliaire (Bt, -Bt) superposé à un champ magnétique (Bx) à mesurer, dans lequel est prévu un premier élément sommateur (12a) pour la détermination d'une partie (Vt) d'une tension de départ (Vma, Vmb) générée uniquement par le champ magnétique auxiliaire (Bt) du système de capteur de champ magnétique (1a, 1b),
   - comprenant un corrélateur (6) qui est relié côté entrée du moins à la sortie d'un premier élément sommateur (12a) et qui est d'autre part relié à une sortie de signaux de tension (Vg) du générateur de signaux auxiliaires (3),

   **caractérisé en ce que**
   le système de circuit est réalisé sous forme d'un circuit intégré,
   côté sortie du corrélateur (6), dans un circuit en série, sont disposés un premier convertisseur A/N (14), un régulateur numérique (28) et un convertisseur N/A (17),
   à l'aide d'une composante variable de grandeur de réglage (Vd) générée côté sortie de ce circuit en série (14, 28, 17) et d'une composante constante de grandeur de réglage (Vb, Is) qui lui est ajoutée, on peut compenser la modification du facteur de transmission du système de capteur de champ magnétique (1a, 1b),
   qu'il est prévu un deuxième élément sommateur (12b) pour déterminer une partie (Vx) de la tension de départ (Vma, Vmb) du système de capteur de champ magnétique (1a, 1b) générée uniquement par le champ magnétique à mesurer (Bx) et
que, côté sortie du deuxième élément sommateur (12b), est disposé un autre convertisseur A/N (20), sachant qu'on peut influer sur la fonction de transmission de ce dernier et la fonction de transmission du premier convertisseur A/N (14) au moyen de la somme (Vrx) de la composante variable de grandeur de réglage (Vd) et de la composante constante de grandeur de réglage (Vb).

2. Système de circuit selon la revendication 1, **caractérisé en ce que** la composante variable de grandeur de réglage (Vd) peut être communiquée par un premier élément de commande (19) au système de capteur de champ magnétique (1a, 1b).

3. Système de circuit selon la revendication 2, **caractérisé en ce que** le premier élément de commande (19) comporte, en circuit en série, une source de courant contrôlée par tension (19a) pour générer une composante variable de grandeur de réglage (Id) en fonction de la composante variable de grandeur de réglage (Vd) et un sixième élément sommateur (19c), sachant qu'au moyen de ce sixième élément sommateur (19c), une composante constante de grandeur de réglage (Is) peut être rajoutée à la composante variable de grandeur de réglage (Id).

4. Système de circuit selon la revendication 3, **caractérisé en ce que** le sixième élément sommateur (19c) est relié à une source de courant auxiliaire (19c) afin de délivrer la composante constante de grandeur de réglage (Is).

5. Système de circuit selon la revendication 3, **caractérisé en ce que** le sixième élément sommateur (19c) est relié au générateur de tension-courant (4) afin de délivrer la composante constante de grandeur de réglage (Is).

6. Système de circuit selon une des revendications 1 à 5, **caractérisé en ce qu'**un deuxième élément de commande (18) est prévu entre le convertisseur N/A (17) et le premier (14) ou l'autre convertisseur A/N (20) qui fournit une tension de référence (Vrx) pour le premier (14) ou l'autre convertisseur A/N (20).

7. Système de circuit selon une des revendications 1 à 6, **caractérisé en ce que** le deuxième élément de commande (18) comprend une source de tension auxiliaire (18b) ayant une tension auxiliaire constante (Vb) et un troisième élément sommateur (18a) pour l'adjonction de la composante variable de grandeur de réglage (Vd) et de la tension auxiliaire (Vb).

8. Système de circuit selon une des revendications 1 à 7, **caractérisé en ce qu'**entre le premier convertisseur A/N (14) et le régulateur numérique (29), est disposé un quatrième élément sommateur (7) qui est relié côté entrée à un indicateur de valeur théorique (8) et au premier convertisseur A/N (14) et qui est relié côté sortie au régulateur numérique (28).

9. Système de circuit selon une des revendications 1 à 7, **caractérisé en ce qu'**entre le premier élément sommateur (12a) et le corrélateur (6), est disposé un cinquième élément sommateur (10), la sortie du premier élément sommateur (12a) étant reliée à l'entrée du cinquième élément sommateur (10) et une autre entrée du cinquième élément sommateur (10) étant reliée par un élément d'atténuation (11) à la sortie de signaux de tension (Vg) du générateur de signaux auxiliaires (3).

10. Système de circuit selon une des revendications précédentes, **caractérisé en ce que** le premier convertisseur A/N est réalisé sous forme d'un modulateur $\Sigma/\Delta$.

11. Procédé de compensation de modifications d'un facteur de transmission d'un système de capteur de champ magnétique (1a, 1b),

- dans lequel, au moyen d'un système de bobine (5a, 5b) raccordé à un générateur de signaux auxiliaires (3) avec un transformateur de courant de tension (4) branché en aval, un champ magnétique auxiliaire (Bt) superposé à un champ magnétique à mesurer (Bx) est généré,
- dans lequel, au moyen d'un premier élément sommateur (12a), une partie (Vt) d'une tension de départ (Vma, Vmb) du système de capteur de champ magnétique (1a, 1b) générée uniquement par le champ magnétique auxiliaire (Bt) est déterminée,
- dans lequel cette partie (Vt) de la tensin de départ (Vma, Vmb) générée uniquement par le champ magnétique auxiliaire (Bt) est conduite à une première entrée d'un corrélateur (6) et dans lequel un signal de tension (Vg) du générateur de signaux auxiliaires (3) est conduit à une deuxième entrée du corrélateur (6),

**caractérisé en ce que**

un signal de sortie (Vk) du corrélateur (6) est, en circuit en série, communiqué à un convertisseur A/N (14), à un régulateur numérique (28) et à un convertisseur N/A (17),

qu'on compense par une composante variable de grandeur de réglage (Vd, Id) générée côté sortie de ce circuit en série (14, 28, 17) et une composante constante de grandeur de réglage (Vb, Is) qui lui est ajoutée, la modification du facteur de transmission du système de capteur de champ magnétique (1a, 1b),

qu'on détermine, au moyen d'un deuxième élément sommateur (12b), une partie (Vx) de la tension de départ (Vma, Vmb) du système de capteur de champ magnétique (1a, 1b) générée uniquement par le champ magnétique à mesurer (Bx),

que, côté sortie du deuxième élément sommateur (12b), est disposé un autre convertisseur A/N/ (20) et

qu'afin de compenser la modification du facteur de transmission du système de détecteur de champ magnétique (1a, 1b), le facteur de transmission respectif du premier (14) et du deuxième convertisseur A/N (20) est réglé à l'aide de la deuxième composante variable de grandeur de réglage (Vd) générée côté sortie du circuit en série (14, 28, 17) et de la composante constante de grandeur de réglage (Vb) qui lui est ajoutée.

12. Procédé selon la revendication 11, **caractérisé en ce que** la composante variable de grandeur de réglage (Vd) est communiquée par un premier élément de commande (19) au système de capteur de champ magnétique (1a, 1b) .

13. Procédé selon la revendication 12, **caractérisé en ce que** le premier élément de commande (19) comporte, en circuit en série, une source de courant (19a) contrôlée par tension pour la génération d'une composante variable de grandeur de réglage (Id) en fonction de la composante variable de grandeur de réglage (Vd) et un sixième élément sommateur (19c), dans lequel, au moyen de ce sixième élément sommateur (19c), une composante constante de grandeur de réglage (Is) est ajoutée à la composante variable de grandeur de réglage (Id).

14. Procédé selon la revendication 13, **caractérisé en ce que** la composante constante de grandeur de réglage (Is) est communiquée au sixième élément sommateur (19c) au moyen d'une source de courant auxiliaire (19b).

15. Procédé selon la revendication 13, **caractérisé en ce que** la composante constante de grandeur de réglage (Is) est communiquée au sixième élément sommateur (19c) au moyen du transformateur de tension-courant (4).

16. Procédé selon une des revendications 11 à 15, **caractérisé en ce que**, côté sortie du circuit en série (14, 28, 17), est disposé un deuxième élément de commande (18) dans lequel, à la composante variable de grandeur de réglage (Vd), est ajoutée la composante constante de grandeur de réglage (Vb) d'une source de tension auxiliaire (18b) au moyen d'un troisième élément sommateur (18a).

17. Procédé selon une des revendications 11 à 16, **caractérisé en ce que**, au signal de sortie du premier convertisseur A/N (14) est ajoutée, au moyen d'un quatrième élément sommateur (7), une valeur théorique réglable (Ns) et qu'au moyen de la valeur théorique réglable individuellement (Ns), à l'état neuf, la plage de réglage du régulateur numérique (28) est réglée à sa valeur moyenne afin de tenir compte d'une dispersion exemplaire du système de circuit.

18. Procédé selon une des revendications 11 à 17, **caractérisé en ce que**, au signal de sortie (Vt) du deuxième élément sommateur (12a) est ajoutée, au moyen d'un cinquième élément sommateur (10), une tension d'atténuation réglable individuellement (Vz) qui est constituée du signal de tension (Vg) du générateur de signaux auxiliaires (3) guidé dans un élément d'atténuation (11) et qu'au moyen de la tension d'atténuation réglable individuellement (Vz), à l'état neuf, la plage de réglage du régulateur numérique (28) est réglée à sa valeur moyenne afin de tenir compte d'une dispersion exemplaire du système de circuit.

Fig 1

EP 1 512 021 B1

Fig 4

18a

Vrx ◄─── ⊕ ─── Vd ◄─── Vd

+

Vb +

Vb

18b

18

Fig 2

It

4

Vg ──► ☒ 4a

Ig ┄┄►

Ig

Ig

4b

Fig 3

19

19c 19a

Ir ◄─── ⊕ ◄─── Id ◄─── Vd

+

Is +

Ig ┄┄►

19b